Europäisches Patentamt

European Patent Office

Office européen des brevets

(19)

(11) EP 0 683 856 B1

(12)

# FASCICULE DE BREVET EUROPEEN

(45) Date de publication et mention
de la délivrance du brevet:
**04.09.1996 Bulletin 1996/36**

(51) Int Cl.6: **F02D 41/24**, F01N 9/00,
G01R 19/165

(21) Numéro de dépôt: **94906204.6**

(86) Numéro de dépôt international:
**PCT/EP94/00297**

(22) Date de dépôt: **02.02.1994**

(87) Numéro de publication internationale:
**WO 94/18445 (18.08.1994 Gazette 1994/19)**

(54) **PROCEDE ET DISPOSITIF DE MESURE NUMERIQUE D'UNE TENSION VARIANT DANS UNE PLAGE DE TENSION PREDETERMINEE ET LEURS UTILISATIONS**

VERFAHREN UND VORRICHTUNG ZUR DIGITALEN MESSUNG EINER SPANNUNG, DIE INNERHALB EINES VORBESTIMMTEN SPANNUNGSBEREICHS VARIIERT UND IHRE ANWENDUNGEN

DEVICE AND METHOD FOR DIGITALLY MEASURING A VOLTAGE VARYING WITHIN A GIVEN RANGE, AND USES THEREOF

(84) Etats contractants désignés:
**DE ES GB IT**

(30) Priorité: **10.02.1993 FR 9301468**

(43) Date de publication de la demande:
**29.11.1995 Bulletin 1995/48**

(73) Titulaire: **SIEMENS AUTOMOTIVE S.A.**
**F-31036 Toulouse Cédex (FR)**

(72) Inventeur: **TORNARE, Jean-Marc**
**12, impasse des Zinnias F-31200 Toulouse (FR)**

(74) Mandataire: **Fuchs, Franz-Josef, Dr.-Ing. et al**
**Postfach 22 13 17**
**80503 München (DE)**

(56) Documents cités:
**EP-A- 0 492 989** **EP-A- 0 503 882**
**DE-A- 4 106 308** **FR-A- 2 615 017**

## Description

La présente invention est relative à un procédé et à un dispositif de mesure numérique d'une tension analogique variant dans une plage de tension prédéterminée et, plus particulièrement, à l'utilisation d'un tel dispositif pour la mesure d'une température.

En électronique automobile, il est souvent nécessaire de mesurer la température de certains fluides, huile, eau de refroidissement, ou d'organes tels qu'un pot catalytique d'oxydoréduction des gaz d'échappement d'un véhicule automobile ou une sonde à oxygène utilisée dans un dispositif de régulation du mélange air/carburant d'alimentation du moteur d'un tel véhicule. Couramment, un capteur de température approprié fournit un signal électrique analogique à un convertisseur analogique-numérique qui délivre une expression numérique de la mesure de température, propre à être exploitée par un calculateur formant partie d'un dispositif de commande ou de régulation prévu dans le véhicule.

Le signal délivré par le capteur est normalement une tension électrique. Quand la température surveillée fait l'objet d'une régulation, celle-ci maintient ce signal dans une plage de tension prédéterminée. C'est ainsi qu'on connaît des sondes à oxygène associées à une résistance de chauffage actionnée de manière à maintenir la température de la sonde dans une plage de température assez étroite, de 650 à 750°C par exemple, plage dans laquelle le signal délivré par la sonde est exploitable. Si on évalue la température de la sonde à partir de celle de la résistance de chauffage, dont la valeur est fonction de cette température, la tension prélevée aux bornes de celle-ci pour ce faire varie elle aussi dans une plage dont les bornes sont fixées par les limites de la plage de température précitée.

De même, on a demandé que la température d'un pot catalytique soit connue d'un calculateur, autour d'une température de fonctionnement optimal de 850°C par exemple, avec une précision fixée de quelques pourcent. Si on utilise un thermocouple pour ce faire, la tension de sortie de celui-ci varie de manière correspondante dans une plage de tension prédéterminée.

Se pose alors le problème de la précision de la mesure numérique de la tension image de la température observée. Cette précision est fonction de la tension de référence $V_{ref}$ du convertisseur et du nombre de bits n de la mesure N qu'il délivre. Or, dans les applications mentionnées ci-dessus, la mesure de la tension n'est intéressante que dans une plage de tension prédéterminée qui ne correspond pas, à priori, à la dynamique de la chaîne de mesure numérique utilisée, qui dépend de paramètres indépendants ($V_{ref}$,n) de cette plage.

La présente invention a donc pour but de fournir un procédé de mesure numérique d'une tension variant dans une plage prédéterminée, à l'aide d'une chaîne de mesure comprenant un convertisseur analogique-numérique, ce procédé permettant d'atteindre une précision de mesure maximale dans cette plage.

La présente invention a aussi pour but de fournir un tel procédé adapté à la mesure d'une tension analogique affectée par la tension délivrée par une source d'alimentation électrique éventuellement fluctuante, comme c'est le cas de la tension délivrée par la batterie d'un véhicule automobile, ce procédé permettant d'obtenir une mesure numérique débarrassée de l'influence des fluctuations de ladite tension.

La présente invention a encore pour but d'utiliser un dispositif pour la mise en oeuvre de ce procédé, utilisable notamment dans une chaîne de mesure de température.

On atteint ces buts de l'invention, ainsi que d'autres qui apparaîtront dans la suite de la présente description, avec un procédé suivant lequel a) on amplifie la tension à mesurer avec un gain proportionnel au rapport de la tension de référence du convertisseur analogique-numérique utilisé, à l'étendue de la plage de variation de cette tension, b) on amplifie la tension de référence avec un gain proportionnel au rapport de la borne inférieure de la plage de variation de tension à l'étendue de cette plage de variation et c) on alimente l'entrée analogique du convertisseur avec la différence des tensions ainsi amplifiées.

Comme on l'expliquera en détail dans la suite, ce procédé permet d'adapter la dynamique du convertisseur à l'étendue de la plage de tension de manière à maximiser avantageusement la précision de la mesure délivrée par le convertisseur.

Suivant une variante du procédé selon l'invention, adaptée à la mesure d'une tension analogique affectée par la tension délivrée par une source d'alimentation électrique éventuellement fluctuante, on alimente le convertisseur avec une tension de référence proportionnelle à la tension électrique fluctuante, de manière à rendre la mesure numérique délivrée par le convertisseur indépendante des fluctuations de ladite tension.

Cette variante est particulièrement utile en électronique automobile car on sait qu'alors la source de tension électrique normalement utilisée est la batterie du véhicule, dont la tension de sortie connaît couramment des fluctuations très importantes, de 4 à 15 volts par exemple pour une tension nominale de 12 volts.

Pour la mise en oeuvre de ce procédé, l'invention fournit un dispositif comprenant un convertisseur analogique-numérique et une source de tension de référence ($V_{ref}$) pour l'alimentation de ce convertisseur, ce dispositif est remarquable en ce qu'il comprend des moyens d'amplification alimentés par la tension analogique ($U_e$) à mesurer et par la tension de référence ($V_{ref}$) pour délivrer à l'entrée analogique du convertisseur une tension de sortie ($U_s$) telle que :

$$U_s = \frac{V_{ref}}{U_2 - U_1} \cdot U_e - \frac{U_1}{U_2 - U_1} \cdot V_{ref}$$

$U_1$ et $U_2$ étant respectivement les bornes inférieure et supérieure de la plage de tension prédéterminée.

D'autres avantages de la présente invention apparaîtront à la lecture de la description qui va suivre et à l'examen du dessin annexé dans lequel :

- la figure 1 est un graphe utile à la présentation du procédé suivant la présente invention,
- la figure 2 est un schéma fonctionnel d'un dispositif pour la mise en oeuvre du procédé suivant la présente invention,
- la figure 3 illustre un mode de réalisation du dispositif schématisé à la figure 2,
- la figure 4 est un schéma d'un dispositif de mesure d'une température à l'aide d'un thermocouple, mettant en oeuvre le procédé suivant l'invention, et
- la figure 5 est un schéma d'un dispositif de mesure de la température d'une sonde à oxygène, correspondant à une autre utilisation du procédé suivant l'invention.

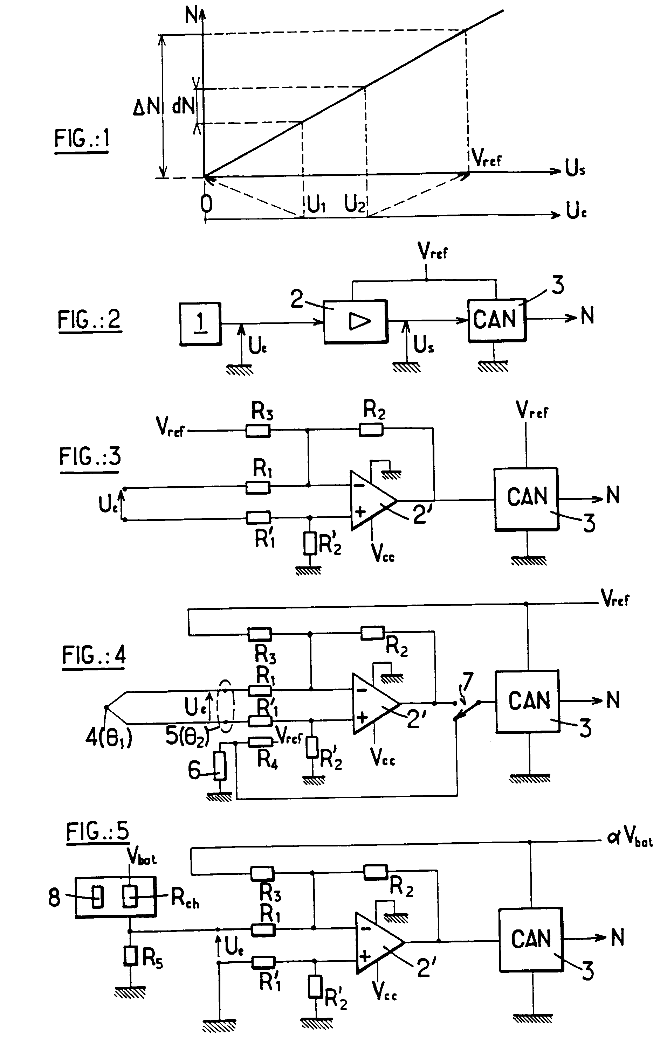

Sur l'axe $U_e$ de la figure 1, on a repéré une plage de tension $(U_1, U_2)$ prédéterminée dans laquelle varie une tension $U_e$ à mesurer. On a représenté également à la figure 1, en regard, le graphe de la sortie N d'un convertisseur analogique-numérique alimenté par une tension de référence $V_{ref}$.

Si $U_1 < U_2 < V_{ref}$, on voit que la plage de variation dN de la sortie du convertisseur analogique-numérique correspondant à la plage $(U_1, U_2)$ est beaucoup plus petite que la dynamique $\Delta N$ du convertisseur, ceci au dépend de la précision de la mesure numérique de la tension à mesurer, dont la résolution est proportionnelle à la tension de référence $V_{ref}$ et inversement proportionnelle à $2^n$, n étant le nombre de bits de la sortie du convertisseur.

Suivant la présente invention, on maximise la précision de la mesure de tension à opérer en adaptant la plage de tension $[0, V_{ref}]$ du convertisseur à la plage de tension $[U_1, U_2]$. Pour cela on fait correspondre la tension $U_1$ au 0 de la plage de mesure du convertisseur et la tension $U_2$ à la tension $V_{ref}$. Cette plage de mesure est alors graduée sur la totalité des $2^n$ niveaux de la sortie N du convertisseur et non sur une fraction de ces $2^n$ niveaux, ce qui améliore ainsi la précision de la mesure d'une tension $U_e$ comprise dans cette plage de mesure. Un calculateur, alimenté par la sortie du convertisseur et chargé avec la valeur de tension $U_1$ correspondant au 0 de la sortie du convertisseur, établit ainsi la tension $U_e$ avec la plus grande précision possible, compte tenu des caractéristiques du convertisseur analogique-numérique utilisé.

On se réfère à la figure 2 du dessin annexé pour décrire un dispositif conçu pour la mise en oeuvre de la présente invention. Un capteur 1 délivrant un signal de tension $U_e$ à mesurer est connecté à des moyens d'amplification 2 dont la sortie $U_s$ alimente un convertisseur analogique-numérique 3, alimenté lui-même par une tension de référence $V_{ref}$.

Suivant la présente invention, les moyens d'amplification 2 sont alimentés en outre par la tension de référence $V_{ref}$ et délivrent une tension de sortie $U_s$ telle que :

$$U_s = K.U_e - K'.V_{ref} \qquad (1)$$

K et K' étant des constantes établies comme suit.

Suivant l'invention, les tensions $U_1$ et $U_2$ correspondent respectivement à des tensions 0 et $V_{ref}$ en sortie des moyens d'amplification 2, soit, par application de la relation (1) ci-dessus :

$$0 = K.U_1 - K'.V_{ref}$$

$$V_{ref} = K.U_2 - K'.V_{ref}$$

On tire de ces relations :

$$K = \frac{V_{ref}}{U_2 - U_1}$$

$$K' = \frac{U_1}{U_2 - U_1}$$

La relation (1) s'exprime alors de la façon suivante :

$$U_s = \frac{V_{ref}}{U_2 - U_1} \cdot U_e - \frac{U_1}{U_2 - U_1} \cdot V_{ref} \qquad (2)$$

Ainsi, en amplifiant dans les moyens 2 les tensions $U_e$ et $V_{ref}$ avec les gains d'amplification K et K' calculés comme indiqué ci-dessus et en alimentant l'entrée analogique du convertisseur 3 avec la différence $U_s$ de ces tensions amplifiées, on peut tirer de la sortie N du convertisseur et d'une mesure numérique enregistrée de la tension $U_1$, une mesure de la tension $U_e$ dont la précision est aussi grande que possible, le pas de la mesure étant égal à $V_{ref}/2^n$, n étant le nombre de bits de la sortie N du convertisseur 3. Grâce aux moyens d'amplification 2, à une tension d'entrée $U_e = U_1$ correspond une sortie $N = 0$ du convertisseur 3 et à une tension $U_e = U_2$ correspond $N = 2^n$.

On a représenté à la figure 3 du dessin annexé, un mode de réalisation du dispositif schématisé à la figure 2. Les moyens d'amplification sont constitués par un amplificateur différentiel 2' alimenté d'une part, à travers des résistances de charge $R_1$ et $R'_1$, entre ses entrées inverseuse et non inverseuse respectivement, par la tension $U_e$ à mesurer et, d'autre part, par une tension de décalage fonction de la tension de référence $V_{ref}$ du convertisseur. Une résistance $R_2$ de réaction est montée entre la sortie de l'amplificateur et l'entrée inverseuse pour établir, en combinaison avec la résistance $R_1$ le gain de l'amplificateur vis-à-vis de la tension d'entrée $U_e$ alors que la tension de référence $V_{ref}$ du convertisseur est ramenée sur une borne d'une résistance $R_3$ dont l'autre borne, commune avec la résistance $R_2$, est connectée à l'entrée inverseuse de l'amplificateur. L'entrée non inverseuse est connectée à la masse à travers une résistance $R'_2$. Dans ces conditions, on démontre que la relation (2) ci-dessus devient :

$$U_s = \frac{R_2}{R_1} \cdot U_e \frac{R_2}{R_3} \cdot V_{ref}$$

avec

$$R_2' = \frac{R_2 \cdot R_3}{R_2 + R_3} \ et \ R_1 = R_1'$$

Une première utilisation de l'invention, à la mesure d'une tension variant dans une plage prédéterminée délivrée par un thermocouple, est illustrée à la figure 4. La chaîne de mesure représentée comprend un thermocouple dont la jonction "chaude" 4 est à une température $\theta_1$ à mesurer alors que sa jonction de référence 5 est à une température $\theta_2$. On sait qu'un tel thermocouple délivre une tension :

$$U_e = f(\theta_1 - \theta_2)$$

La tension $U_e$ alimente un dispositif identique à celui de la figure 3. Une même référence repère des organes ou éléments identiques ou similaires sur les figures 3 à 5. On comprend qu'un calculateur puisse déterminer la valeur de la température $\theta_1$ à partir de la fonction f et d'une mesure de la tension $U_e$, la température $\theta_2$ étant supposée fixe et connue.

Quand la température $\theta_2$ de la jonction de référence est susceptible de varier (c'est le cas par exemple si elle se trouve à la température ambiante) on prévoit, suivant l'invention, des moyens sensibles à la température de cette jonction et propres à délivrer un signal de correction permettant au calculateur de corriger convenablement le calcul de la température $\theta_1$.

Pour ce faire, on dispose un capteur de température tel qu'une thermistance 6, à proximité de la jonction de référence 5, les variations de la résistance de la thermistance 6 faisant varier la tension au point milieu d'un pont de résistances ($R_4$,6) alimenté par la tension $V_{ref}$ par exemple. Le calculateur commande périodiquement un moyen de commutation 7 pour connecter le point milieu du pont à l'entrée du convertisseur 3 qui délivre alors au calculateur une mesure numérique de la température $\theta_2$. Un tel dispositif est utile notamment lorsqu'il faut disposer une sonde de température à une distance éloignée du calculateur, comme c'est le cas, par exemple, lorsqu'on mesure la température d'un pot catalytique d'oxydoréduction des gaz d'échappement d'un moteur à combustion interne propulsant un véhicule automobile.

Une autre utilisation "automobile" de la présente invention est représentée à la figure 5. Il s'agit là de mesurer la température d'une sonde à oxygène 8 chauffée par une résistance de chauffage $R_{ch}$. Comme on l'a vu plus haut, la température d'une telle sonde doit être maintenue dans une plage relativement étroite. A cet effet, un dispositif de régulation de cette température commande l'alimentation de la résistance de chauffage. Celle-ci peut être considérée comme étant en équilibre thermique avec la sonde 8 qu'elle chauffe. On peut connaître la température de la sonde par celle de la résistance de chauffage supposée en équilibre thermique avec la sonde, résistance qui varie avec la température, comme il est bien connu. Cette mesure s'opère en prélevant la tension $U_e$ du point milieu d'un pont constitué par la résistance $R_{ch}$ et une résistance fixe $R_5$ montées en série entre la borne positive de la batterie du véhicule et la masse. Cette tension varie en sens inverse de la variation de la résistance de $R_{ch}$, quand celle-ci présente classiquement un coefficient de température positif. La mesure de cette tension par un calculateur alimenté par la sortie du convertisseur 3 d'un dispositif par ailleurs conforme à ceux représentés aux figures 3 et 4, permet donc de remonter à la température de la sonde 8.

Dans un véhicule automobile, la tension +$V_{bat}$ délivrée par la batterie est susceptible de fluctuations très larges, comme on l'a vu plus haut. De telles fluctuations faussent alors la mesure opérée car elles affectent l'alimentation de la résistance de chauffage.

On pallie cet inconvénient, suivant la présente invention, en tirant la tension de référence $V_{ref}$ du convertisseur de la tension +$V_{bat}$ délivrée par la batterie de manière que celles-ci varient dans le même sens. On obtient ainsi une compensation automatique des effets d'une fluctuation de la tension batterie. Celle-ci étant en général plus élevée que la tension maximale supportable par le convertisseur sur sa broche de tension de référence, c'est seulement une fraction $\alpha V_{bat}$ ($\alpha < 1$) de la tension de sortie de la batterie qui alimente le dispositif suivant l'invention.

Bien entendu la présente invention n'est pas limitée aux modes de réalisation décrits et représentés qui n'ont été donnés qu'à titre d'exemple. Ainsi l'invention est applicable avantageusement à la mesure numérique de toute grandeur accessible par une tension variant dans une plage prédéterminée, et non pas seulement à la mesure d'une température.

**Revendications**

1. Procédé de mesure numérique d'une tension analogique ($U_e$) variant dans une plage de tension prédéterminée ($U_1$,$U_2$), la mesure étant délivrée par un convertisseur analogique-numérique (3) alimenté par une tension de référence ($V_{ref}$), caractérisé en ce que a) on amplifie la tension ($U_e$) à mesurer avec un gain proportionnel au rapport de la tension de référence ($V_{ref}$) à l'étendue ($U_2 - U_1$) de ladite plage de tension, b) on amplifie la tension de référence ($V_{ref}$) avec un gain proportionnel au rapport de la borne inférieure ($U_1$) de la plage de tension à l'étendue ($U_2 - U_1$) de cette plage de tension, et c) on alimente l'entrée analogique du convertisseur avec la différence des tensions ainsi amplifiées.

2. Procédé conforme à la revendication 1, pour la mesure d'une tension analogique affectée par la tension (+V$_{bat}$) délivrée par une source d'alimentation électrique éventuellement fluctuante, caractérisé en ce qu'on alimente le convertisseur avec une tension de référence (V$_{ref}$) proportionnelle à la tension électrique fluctuante (+V$_{bat}$), de manière à rendre la mesure numérique délivrée par le convertisseur indépendante des fluctuations de ladite tension (+V$_{bat}$).

3. Dispositif pour la mise en oeuvre du procédé conforme à l'une quelconque des revendications 1 et 2, comprenant un convertisseur analogique-numérique (3) et une source de tension de référence V$_{ref}$ pour l'alimentation de ce convertisseur, caractérisé en ce qu'il comprend des moyens d'amplification (2; 2') alimentés par la tension analogique U$_e$ à mesurer et par la tension de référence V$_{ref}$ pour délivrer à l'entrée analogique du convertisseur (3) une tension de sortie U$_s$ telle que :

$$U_s = \frac{V_{ref}}{U_2 - U_1} \cdot U_e \frac{U_1}{U_2 - U_1} \cdot V_{ref}$$

U$_1$ et U$_2$ étant respectivement les bornes inférieure et supérieure de la plage de tension prédéterminée.

4. Dispositif conforme à la revendication 3, caractérisé en ce que lesdits moyens d'amplification comprennent un amplificateur différentiel (2') et des moyens de décalage (V$_{ref}$,R$_3$) de la tension appliquée à l'une de ses entrées.

5. Utilisation du dispositif conforme à la revendication 3 ou 4, pour la mesure d'une température relevée à l'aide d'un thermocouple délivrant une tension analogique de sortie (U$_e$) proportionnelle à cette température.

6. Utilisation conforme à la revendication 5, caractérisée par des moyens (V$_{ref}$,R$_4$,6) de formation d'une tension électrique fonction de la température (θ$_2$) de la jonction de référence (5) du thermocouple, et par des moyens (7) pour commuter cycliquement l'entrée analogique du convertisseur (3) sur cette tension de manière que ce dernier délivre une mesure numérique de ladite tension, propre à corriger la mesure de température tirée du thermocouple.

7. Utilisation conforme à la revendication 6, caractérisée en ce que lesdits moyens de formation comprennent une thermistance (6) disposée de manière à être sensible à la température (θ$_2$) de la jonction de référence (5), ladite thermistance formant partie d'un pont de résistances (R$_4$,6) alimenté par la tension de référence (V$_{ref}$), ladite tension étant prélevée au point milieu du pont.

8. Utilisation du dispositif conforme à la revendication 3, pour la mesure de la température d'une sonde à oxygène (8) chauffée par une résistance électrique (R$_{ch}$), par l'intermédiaire de la mesure de la tension (U$_e$) du point milieu d'un pont constitué par la résistance de chauffage (R$_{ch}$) et une résistance fixe (R$_5$), et alimenté par une source de tension.

9. Utilisation conforme à la revendication 8, caractérisée en ce que la source de tension est constituée par la batterie d'un véhicule automobile et en ce que la tension de référence (V$_{ref}$) alimentant le convertisseur (3) est proportionnelle à la tension (+V$_{bat}$) délivrée par la batterie.

**Patentansprüche**

1. Verfahren zur digitalen Messung einer in einem vorgegebenen Spannungsbereich (U$_1$, U$_2$) veränderlichen analogen Spannung (U$_e$), bei dem die Messung von einem mit einer Bezugsspannung (V$_{ref}$) gespeisten Analog/Digital-Wandler (3) geliefert wird, dadurch gekennzeichnet, daß
a) die zu messende Spannung (U$_e$) mit einem Verstärkungsfaktor, der dem Verhältnis der Bezugsspannung (V$_{ref}$) zur Erstreckung (U$_2$ - U$_1$) des Spannungsbereichs proportional ist, verstärkt wird, b) die Bezugsspannung (V$_{ref}$) mit einem Verstärkungsfaktor, der dem Verhältnis des unteren Wertes (U$_1$) des Spannungsbereiches zu der Erstreckung (U$_2$ - U$_1$) dieses Spannungsbereiches proportional ist, verstärkt wird, und c) der analoge Eingang des Wandlers mit der Differenz der auf diese Weise verstärkten Spannungen beaufschlagt wird.

2. Verfahren nach Anspruch 1 zur Messung einer analogen Spannung, die durch die Spannung (+V$_{bat}$) beeinflußt wird, welcher von einer gegebenenfalls Schwankungen unterliegenden elektrischen Versorgungsquelle geliefert wird, dadurch gekennzeichnet, daß der Wandler mit einer Bezugsspannung (V$_{ref}$), die der den Schwankungen unterliegenden elektrischen Spannung (+V$_{bat}$) proportional ist, beaufschlagt wird, um den vom Wandler abgegebenen digitalen Meßwert von den Schwankungen der betreffenden Spannung (+V$_{bat}$) unabhängig zu machen.

3. Vorrichtung zum Durchführen des Verfahrens nach einem der Ansprüche 1 und 2 mit einem Analog/Digital-Wandler (3) und einer Bezugsspannungsquelle zum Beaufschlagen des Wandlers, dadurch gekennzeichnet, daß sie Verstärkungsmittel (2;2') aufweist, die mit der zu messenden analogen Spannung (U$_e$) und der Bezugsspannung (V$_{ref}$) beaufschlagt werden, um an den analogen Eingang des Wandlers (3) eine Ausgangsspannung (U$_a$) wie folgt abzugeben:

$$U_s = \frac{V_{ref}}{U_2 - U_1} \cdot U_e - \frac{U_1}{U_2 - U_1} \cdot V_{ref}$$

worin $U_1$ und $U_2$ die untere Grenze bzw. die obere Grenze des vorgegebenen Spannungsbereichs sind.

4. Vorrichtung nach Anspruch 3, dadurch gekennzeichnet, daß die Verstärkungsmittel einen Differentialverstärker (2') und Mittel zum Shiften ($V_{ref}$, $R_3$) der an den einen seiner Eingänge angelegten Spannung aufweisen.

5. Anwendung der Vorrichtung nach Anspruch 3 oder 4 zur Messung einer Temperatur, die mit Hilfe eines Thermoelementes überwacht wird, das eine zu dieser Temperatur proportionale analoge Ausgangsspannung ($U_e$) abgibt.

6. Anwendung nach Anspruch 5, gekennzeichnet durch Mittel für ($V_{ref}$, $R_4$, 6) zum Erzeugen einer elektrischen Spannung in Abhängigkeit von der Temperatur ($\theta_2$) des Bezugsanschlusses (5) des Thermoelementes und durch Mittel (7) zum zyklischen Umschalten des analogen Eingangs des Wandlers (3) auf diese Spannung, derart, daß der letztere einen digitalen Ifeßwert dieser Spannung liefert, mit der sich der von dem Thermoelement erhaltenen Temperaturmeßwert korrigieren läßt.

7. Anwendung nach Anspruch 6, dadurch gekennzeichnet, daß die Erzeugungsmittel einen Thermistor (6) aufweisen, der so angeordnet ist, daß er die Temperatur ($\theta_2$) des Bezugsanschlusses (5) erfassen kann, wobei der Thermistor Teil einer Widerstandsbrücke ($R_4$, 6) bildet, die mit der Bezugsspannung ($V_{ref}$) beaufschlagt wird, wobei diese Spannung in der Mitte der Brücke abgegriffen wird.

8. Anwendung der Vorrichtung nach Anspruch 3 zur Messung der Temperatur einer von einem elektrischen Widerstand ($R_{ch}$) aufgeheizten Sauerstoffsonde (8) über die Messung der Spannung ($U_e$) in der Mitte einer Brücke, die von dem Heizwiderstand ($R_{ch}$) und einem festen Widerstand ($R_5$) gebildet und von einer Spannungsquelle gespeist wird.

9. Anwendung nach Anspruch 8, dadurch gekennzeichnet, daß die Spannungsquelle von der Batterie eines Kraftfahrzeuges gebildet wird und daß die Bezugsspannung ($V_{ref}$), die den Wandler (3) speist, der von der Batterie abgegebenen Spannung ($+V_{bat}$) proportional ist.

## Claims

1. Method for digitally measuring an analog voltage ($U_e$) varying in a predetermined voltage range ($U_1$, $U_2$), the measurement being delivered by an analog-to-digital converter (3) supplied with a reference voltage ($V_{ref}$), characterized in that a) the voltage ($U_e$) to be measured is amplified with a gain proportional to the ratio of the reference voltage ($V_{ref}$) to the extent ($U_2 - U_1$) of the said voltage range, b) the reference voltage ($V_{ref}$) is amplified with a gain proportional to the ratio of the lower limit ($U_1$) of the voltage range to the extent ($U_2 - U_1$) of this voltage range, and c) the analog input of the converter is supplied with the difference between the voltages thus amplified.

2. Method according to Claim I, for measuring an analog voltage affected by the voltage ($+V_{bat}$) delivered by a possibly fluctuating electrical supply source, characterized in that the converter is supplied with a reference voltage ($V_{ref}$) proportional to the fluctuating electric voltage ($+V_{bat}$), so as to make the digital measurement delivered by the converter independent of the fluctuations in the said voltage ($+V_{bat}$).

3. Device for implementing the method according to either of Claims 1 and 2, comprising an analog-to-digital converter (3) and a reference voltage source $V_{ref}$ for supplying this converter, characterized in that it comprises amplification means (2;2') supplied with the analog voltage $U_e$ to be measured and with the reference voltage $V_{ref}$ in order to deliver at the analog input of the converter (3) an output voltage $U_s$ such that:

$$U_s = \frac{V_{ref}}{U_2 - U_1} \cdot U_e - \frac{U_1}{U_2 - U_1} \cdot V_{ref}$$

$U_1$ and $U_2$ being respectively the lower and upper limits of the predetermined voltage range.

4. Device according to Claim 3, characterized in that the said amplification means comprise a differential amplifier (2') and means ($V_{ref}$, $R_3$) for offsetting the voltage applied to one of its inputs.

5. Use of the device according to Claim 3 or 4, for measuring a temperature detected using a thermocouple delivering an analog output voltage ($U_e$) proportional to this temperature.

6. Use according to Claim 5, characterized by means ($V_{ref}$, $R_4$, 6) for forming an electric voltage which is a function of the temperature ($\theta_2$) of the reference junction (5) of the thermocouple, and by means (7) for cyclically switching the analog input of the converter (3) to this voltage, so that the latter delivers a digital measurement of the said voltage, which can correct the temperature measurement derived from the thermocouple.

7. Use according to Claim 6, characterized in that the said formation means comprise a thermistor (6) arranged so as to be sensitive to the temperature ($\theta_2$) of the reference junction (5), the said thermistor forming part of a resistor bridge ($R_4$,6) supplied with the reference voltage ($V_{ref}$), the said voltage being tapped from the centre point of the bridge.

8. Use of the device according to Claim 3, for measuring the temperature of an oxygen probe (8) heated by an electrical resistor ($R_{ch}$), by means of the measurement of the voltage ($U_e$) of the centre point of a bridge, constituted by the heating resistor ($R_{ch}$) and a fixed resistor ($R_5$) and supplied by a voltage source.

9. Use according to Claim 8, characterized in that the voltage source consists of the battery of a motor vehicle, and in that the reference voltage ($V_{ref}$) supplying the converter (3) is proportional to the voltage ($+V_{bat}$) delivered by the battery.

FIG.:1

FIG.:2

FIG.:3

FIG.:4

FIG.:5